Europäisches Patentamt

European Patent Office

Office européen des brevets

(11) Numéro de publication: **0 267 839**
**A1**

## (12) DEMANDE DE BREVET EUROPEEN

(21) Numéro de dépôt: 87402401.1

(22) Date de dépôt: 23.10.87

(51) Int. Cl.⁴: **H 01 L 33/00**
H 01 L 27/15, H 01 S 3/23

(30) Priorité: 23.10.86 FR 8614740

(43) Date de publication de la demande:
18.05.88 Bulletin 88/20

(84) Etats contractants désignés: DE GB

(71) Demandeur: **Menigaux, Louis**
**85 avenue des Tilleuls**
**F-91440 Bures sur Yvette (FR)**

**Dugrand, Louis**
**6, Boulevard d'Alsace Lorraine**
**F-77500 Chelles (FR)**

(72) Inventeur: **Menigaux, Louis**
**85 avenue des Tilleuls**
**F-91440 Bures sur Yvette (FR)**

**Dugrand, Louis**
**6, Boulevard d'Alsace Lorraine**
**F-77500 Chelles (FR)**

(74) Mandataire: **Plaçais, Jean-Yves et al**
**Cabinet Netter 40, rue Vignon**
**F-75009 Paris (FR)**

(54) **Procédé de fabrication d'une structure semi-conductrice susceptible d'effet laser multi-longueurs d'onde, et dispositif obtenu.**

(57) Sur un substrat S, par exemple un arséniure de gallium de type N+, on constitue un empilement de double hétérostructure comprenant des couches de confinement (CC) encadrant des couches actives (CA). Un décapage sélectif est conduit de manière à mettre à nu des couches de confinement de rangs différents, par exemple CC4, CC3, CC2. Les couches de confinement reçoivent d'abord des couches de contact (CP, en arséniure de gallium de type P). A travers cellesci, on constitue des régions RI, R2, R3, qui forment des jonctions avec la couche active supérieure, respectivement (CAI, CA2, CA3). Des vallées (VI0, V2I, V32) sont creusées pour isoler les empilements élémentaires ainsi définis. Après constitution de dépôt métallique de contact, et préparation optique des surfaces extrêmes, on obtient un dispositif laser multi-longueurs d'ondes.

FIG. 6

EP 0 267 839 A1

**Description**

## Procédé de fabrication d'une structure semi-conductrice susceptible d'effet laser multi-longueurs d'onde, et dispositif obtenu.

L'invention concerne les semi-conducteurs, plus particulièrement ceux qui sont susceptibles d'applications en optique.

On sait que lorsqu'une jonction P-N est excitée électriquement, par une tension de commande correspondante à une énergie supérieure à son énergie de bande interdite, elle va répondre par un rayonnement. On appelle ici "semi-conducteurs possédant des propriétés optiques radiatives" ceux pour lesquels ce rayonnement est essentiellement de nature optique, plutot qu'acoustique.

De tels semi-conducteurs sont actuellement obtenus à partir des matériaux dits "alliages III-V", c'est-à-dire réunissant au moins un élément de la colonne III et au moins un élément de la colonne V de la classification périodique de Mendeldeev. En fait, il s'agit des colonnes IIIA et VA, dans la version actuelle de cette classification. Plus précisément encore, on considère d'une part l'aluminium, le gallium et l'indium, d'autre part le phosphore, l'arsenic et l'antimoine.

De manière connue, ces matériaux peuvent avoir ou se voir conférer une conductivité de type N, ou bien de type P, en recevant des impuretés appropriées en faible quantité. La conductivité initiale des alliages III-V est due à leurs propriétés semi-conductrices intrinsèques, ainsi qu'aux impuretés résiduelles dues à leur procédé de fabrication. En ce qui concerne le type de conductivité acquis, on citera par exemple le zinc, le cadmium, le magnésium et le béryllium, qui sont susceptibles de conférer le type P à de l'arseniure de gallium dont la conductivité initiale est de type N. Plus généralement, les impuretés à choisir dans chaque cas étant connues, ou déterminables, elles ne seront pas précisées à chaque fois.

Enfin, l'homme de l'art sait que les structures semi-conductrices sont en général monocristallines, sauf mention contraire.

Parmi d'autres usages, les alliages III-V servent à fabriquer des lasers à semi-conducteurs, ou diodes lasers, qui ont pris une importance considérable depuis la découverte de la diode laser à double hétérostructure. Les diodes lasers s'appliquent notamment aux télécommunications par fibres optiques, ainsi qu'aux lecteurs optiques de disques. Le mot "laser" vise ci-après ces lasers à semi-conducteurs.

Pour augmenter la capacité de transmission de ces systèmes, il est intéressant de recourir à un multiplexage en longueur d'onde, donc de disposer d'un laser "multi-longueurs d'ondes". Mais, alors que les études sur les lasers "mono-longueur d'onde" sont très nombreuses, celles sur les lasers multi-longueurs d'ondes sont beaucoup moins importantes.

Il a été proposé tout d'abord de constituer un empilement de double hétérostructure à couches actives différentes :

- W.T. TSANG, "New Multi-wavelength Transverse-Junction Stripe Lasers Grown by Molecular Beam Epitaxy Operating Predominantly in Single-Longitudinal Modes", Appl. Phys. Lett. 36(6), 15 mars 1980, pp 441-443;

- S. SAKAI, T. AOKI, M. TOBE, M. UMENO et Y. AMEMIYA, "Integrated Light Emitters and Photodetectors for Dual-Channel Optical Communication", ECOC, Sixth European Conference on Optical Communication, Conference Publication 190 pp 230,233;

- T.P. LEE,C.A. BURRUS, A.G. DENTAI, "Dual Wavelength Surface Emitting InGaAsP L.E.D.S." Electronics Letters, 23 octobre 1980, Vol. 16, No 22.

Ces propositions ont l'inconvénient majeur que toutes les longueurs d'ondes y sont excitées en même temps.

Par ailleurs, le multiplexage en fréquence est permis par des diodes lasers intégrant un réseau optique de sélection de longueurs d'ondes, également dénommées diodes lasers à réaction répartie ("distributed feedback"), et décrites dans l'article suivant :

K. AIKI, M. NAKAMURA et J. UMEDA, "Frequency Multiplexing Light Source with Monolithically Integrated Distributed Feedback Diode Lasers", Applied Physics Letters, Vol. 29, No8, 15 octobre 1976.

Cependant, la haute technologie nécessaire pour la réalisation d'un réseau intégré compromet l'usage industriel à grande échelle de ce procédé.

Il a aussi été suggéré de réaliser des lasers dont la couche active présente un gradient de composition :

ZH.I. ALFEROV, E.N. ARUTYUNOV, S.A. GUREVITCH, E.L. PORTNOY, N.V. PRONINA et V.B. SMIRNITSKY, "Wavelength Multiplexing DM Al Ga As Injection Laser Source with a Graded Composition along the Active Layer", IEEE Journal of Quantum Electronics, Vol. QE-17, No 8, Août 1981.

Comme ci-dessus, la technologie de fabrication est extrêmement délicate.

Enfin, ont encore été proposés des lasers obtenus avec des couches actives de compositions différentes, situées dans le même plan :

- N. BOUADMA, J.C. BOULEY, J. RIOU, "Dual Wavelength (GaAl) As Laser", Electronics Letters, 30 septembre 1982, Vol. 18, No 20, PP 871-873.

Cette fois, les moyens de fabrication impliqués sont en eux-mêmes assez bien maîtrisés. Mais il faut un décapage suivi d'une reprise d'épitaxie, pour chacune des longueurs d'ondes supplémentaires souhaitées. Il s'avère qu'après deux ou trois séquences de décapage et de reprise d'épitaxie, les défauts de structure cristalline créés à chacune de ces opérations s'additionnent, ce qui entraîne des difficultés insurmontables.

L'invention vient apporter une solution plus satisfaisante.

L'un des buts de l'invention est de permettre la réalisation d'un laser où chaque longueur d'onde peut être excitée indépendamment, ou simultanément à l'une des autres.

Un autre but de l'invention est de n'utiliser qu'une seule épitaxie multicouches (fabrication de la double hétérostructure en une seule fois), quel que soit le nombre de longueurs d'onde recherché.

L'invention propose une procédé de fabrication d'une structure semi-conductrice, en particulier d'une structure susceptible d'effet laser, remarquable en ce qu'il comporte les opérations suivantes :

a) on dépose sur un substrat un empilement en double hétérostructure monocristalline, constitué de couches actives de compositions différentes, possédant des propriétés optiques radiatives, et encadrées chacune par deux couches de confinement, possédant une dimension de mailles monocristallines voisine de celle des couches actives, toutes ces couches étant du même type de conductivité (type n) ;

b) on décape sélectivement le dessus de l'empilement, selon des bandes parallèles, adjacentes les unes aux autres, pour y mettre à nu des couches de confinement de rangs différents, au moins sur deux bandes adjacentes, les couches de confinement ainsi mises à nu définissant des terrasses parallèles, séparées les unes des autres par des transitions ;

c) lors d'une deuxième étape d'épitaxie, on dépose sur ces terrasses une couche semi-conductrice dite de contact pour faciliter la prise d'un contact ohmique sur la structure.

On peut également arrêter l'attaque de l'étape b) au niveau supérieur de chacune des zones actives; cette zone active qui, comme décrit plus loin, est à moins de l0% d'Al, peut remplacer la couche de contact.

d) dans une bande incluse dans chaque terrasse, on forme, à travers la couche de contact, par introduction d'impuretés correspondant au même type de conductivité que celle-ci, une région localisée de quelques µm de large (4-5) ou non localisée (région de type inversé), jusqu'au voisinage de la couche active sous-jacente, pour constituer avec celle-ci une jonction P-N;

e) on effectue un dépôt métallique pour contacter individuellement chaque région de type inversé;

f) on effectue un dépôt métallique de contact commun, sur la semelle du substrat;

g) on isole électriquement les régions de type inversé les unes des autres, au niveau des transitions qui les séparent, pour former des rubans de structure semi-conductrice; et

h) on prépare optiquement les extrémités opposées de ces rubans, transversalement à la plus grande dimension des terrasses.

A l'heure actuelle, les matériaux susceptibles de constituer une telle double hétérostructure sont des alliages III-V, plus précisément des alliages comprenant d'une part au moins un matériau du groupe : aluminium, gallium et indium, et d'autre part au moins un matériau du groupe: phosphore, arsenic, antimoine.

Dans un mode de réalisation particulier, les couches actives, de type N, ont pour composition $Ga_{1-x} Al_x As$, x différant à chaque fois, et étant inférieur à l0% environ, tandis que les couches de confinement ont pour composition $Ga_{1y} Al_y As$, y étant sensiblement le même pour tous, et égal à 30% environ.

Les couches de la double hétérostructure sont avantageusement déposées par épitaxie, en particulier par épitaxie en phase liquide, ou encore par épitaxie à jet moléculaire, ou bien par dépôt en phase vapeur de composés organo-métalliques.

Pratiquement, l'épaisseur des couches actives est de l'ordre du dixième de micromètre, tandis que celle des couches de confinement est de l'ordre du micromètre.

Pour sa part, la couche de contact peut être avantageusement constituée elle aussi d'un alliage III-V, comme par exemple l'arséniure de gallium de type P, pour le mode de réalisation particulier mentionné plus haut. La couche de contact peut elle aussi être épitaxiée, et d'une épaisseur de 0,2 micromètre.

La région précitée est formée à l'aide d'impuretés dans le groupe comprenant le zinc, le cadmium, le magnésium, le béryllium, et éventuellement le silicium. Elle peut être formée par diffusion, notamment pour le zinc et le cadmium, ou bien par implantation ionique suivie de recuit, ce qui peut s'appliquer à l'ensemble des matériaux indiqués plus haut.

Par ailleurs, cette région peut être réalisée sur la majeure partie de la surface de la terrasse, ou bien localisée seulement à une petite partie de cette surface.

De son côté, l'opération g), pour l'isolation des régions de type inversé, peut être réalisée par un décapage localisé, par voie sèche ou humide, gravant des sillons jusqu'au substrat.

Dans une variante, l'opération g) peut être réalisée par implantation protonique.

Enfin, l'opération h) de préparation optique peut être effectuée soit par clivage, soit par un usinage par voie humide ou sèche.

Le substrat peut être un alliage III-V fortement dopé N, ou bien du silicium.

Dans la mesure où le procédé défini ci-dessus est réalisé sur une plaquette semi-conductrice (wafer) de grandes dimensions, comprenant plusieurs circuits élémentaires, il y aura bien sûr lieu de compléter le procédé par l'opération supplémentaire suivante :

i) séparer la structure semi-conductrice en puces individuelles comprenant chacune au moins deux rubans adjacents.

Bien entendu, l'invention couvre également les dispositifs semi-conducteurs obtenus par le procédé qui vient d'être exposé. En leur structure générale, de tels dispositifs comprennent :

- un substrat,

- au moins deux empilements de double hétérostructure en forme de rubans allongés, disposés côte à côte, et isolés électriquement l'un de l'autre, sur le substrat, ces deux empilements possédant un nombre différent de couches actives, de composition différente, tandis que les petites extrémités de ces rubans sont préparées optiquement,

- deux régions, présentes respectivements dans les deux couches de confinement supérieures, chacune jusqu'au voisinage de la couche active sous-jacente, pour former avec celle-ci une jonction P-N,

- deux couches de contact respectivement disposées sur les deux couches de confinement supérieures,

- deux dépôts de contact sur ces deux couches de contact, et

- un dépôt de contact sur le substrat.

Un pareil dispositif peut notamment s'appliquer en tant que laser à semi-conducteurs multi-longueurs d'ondes.

D'autres caractéristiques et avantages de l'invention apparaîtront à l'examen de la description détaillée ci-après, ainsi que des dessins annexés, sur lesquels

- la figure I illustre schématiquement une double hétérostructure épitaxiée de départ;
- la figure 2 illustre une double hétérostructure ayant subi une première étape de décapage;
- la figure 3 illustre la double hétérostructure de la figure 2, maintenant revêtue d'une couche de contact;
- la figure 4 illustre la double hétérostructure de la figure 3, dans laquelle ont été créées des régions et des jonctions;
- la figure 5 illustre la double hétérostructure de la figure 4, maintenant revêtue de dépôts métalliques de contact; et
- la figure 6 illustre la forme finale du dispositif semiconducteur selon l'invention.

Sur la figure I, on part d'un substrat S qui peut, de manière générale, être constitué d'un semi-conducteur de type N, ou bien de silicium.

Dans la suite de la présente description, on se limitera au cas dit "système Ga As", dans lequel le semi-conducteur de base est donc l'arséniure de gallium.

Dans cette hypothèse, le substrat S est de l'arséniure de gallium, de type N+, c'est-à-dire manifestant une forte conductivité de type N.

La double hétérostructure va être réalisée par épitaxie sur ce substrat, en empilant différentes couches. Différentes techniques d'épitaxie sont connues. On utilisera de préférence l'épitaxie en phase liquide (LPE pour Liquid Phase Epitaxy). En variante, on peut utiliser le dépôt en phase vapeur à partir de composés organiques métalliques (MOCVD, pour Metallo Organic Chimical Vapour Deposition), ou encore l'épitaxie par jet moléculaire (MBE, pour Molecular Beam Epitaxy).

Dans un mode de réalisation particulier, les couches de confinement sont toutes en matériau de type N, de formule générale:

$Ga_{1-y} Al_y As$, c'est-à-dire qu'il s'agit d'un alliage arséniure d'aluminium-gallium, où la proportion d'aluminium est y et celle de gallium I-y. Typiquement, y est de l'ordre de 30%, et l'épaisseur des couches de confinement CC est d'environ I,5 micromètre.

Après l'épitaxie de la première couche de confinement CCI sur le substrat S, on procède à l'épitaxie de la première couche active CAI, dont la composition est par exemple : $Ga_{1-x_1}, Al_{x_1}, As$, c'est-à-dire qu'il s'agit d'un alliage d'arséniure de gallium aluminium, où la proportion des atomes d'aluminium est $x_1$, tandis que celle de gallium est $I-X_1$. L'épaisseur de la couche est typiquement de 0,2 micromètre. La proportion X est choisie entre 0 et I0%, suivant la longueur d'onde désirée, comme on le verra ci-après.

Ensuite, une seconde couche de confinement CC2 est épitaxiée sur la première couche active CAI.

On procéde alors à l'épitaxie de la seconde couche active CA2, dont l'épaisseur est à nouveau d'environ 0,2 micromètre, mais la proportion $x_2$ d'aluminium et de gallium est différente.

Une troisième couche de confinement CC3 est alors réalisée, puis une troisième couche active CA3, avec une proportion $x_3$, et enfin une dernière couche de confinement CC4, qui termine l'empilement en double hétérostructure.

Bien entendu, le nombre de couches de confinement et de couches actives peut être plus ou moins important, suivant le nombre de fréquences différentes que l'on souhaitera pouvoir exciter dans le dispositif laser. L'invention suppose qu'il existe deux couches actives différentes empilées, au moins.

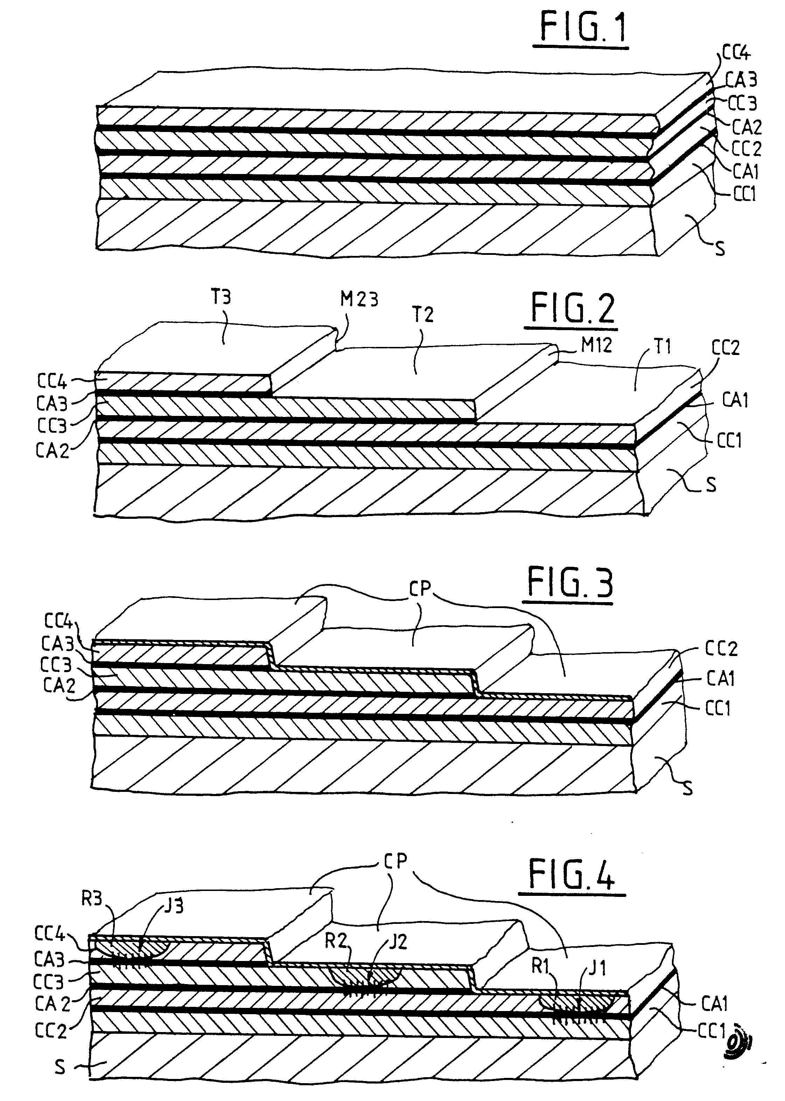

A partir de la double hétérostructure de la figure I, le procédé selon l'invention est suivi d'une étape de photogravure, suivant laquelle on décape, par voie sèche ou humide, les couches épitaxiées de façon à y réaliser des terrasses TI, T2, T3, comme illustré sur la figure 2. En pratique, on fait en sorte que la face supérieure de chaque terrasse se situe à environ I micromètre de la zone active, c'est-à-dire que l'on décape environ 0,5 micromètre de la dernière couche de confinement attaquée dans le cas où il y a épitaxie d'une couche de contact. Dans l'autre cas, où les couches actives elles-mêmes servent de couches de contact, le décapage s'arrête au niveau supérieur de chaque couche active.

Il s'agit là d'une photogravure sélective, puisqu'elle ne s'exercera pas de la même manière, selon des bandes parallèles, adjacentes les unes aux autres, et définies à partir de la face supérieure de l'empilement de la figure I.

En pratique, le décapage a pour but de définir une sorte d'escalier, possédant autant de marches qu'il y aura de couches actives différentes à mettre en oeuvre dans le dispositif laser final.

Pour obtenir cela, on peut commencer par une photogravure intéressant seulement la bande située au niveau de la terrasse TI, puis une photogravure intéressant simultanément les bandes situées au niveau des terrasses TI et T2, puis une troisième photogravure intéressant l'ensemble des bandes.

On obtient alors le profil en escalier illustré sur la figure 2.

Ces photogravures peuvent se faire avec des agents de gravure identiques, ou différents, à chacune des sous-étapes que comporte l'opération générale de photogravure.

La figure 2 fait encore apparaître des transitions MI2 entre les terrasses TI et T2 et M23 entre les terrasses T2 et T3. Il n'est pas nécessaire d'attacher un soin particulier à la régularité de ces transitions, du moins dans la mesure où elles sont enlevées à l'étape finale, comme on le verra ci-après.

L'étape suivante du procédé (figure 3) consiste à déposer sur l'ensemble des terrasses et des transitions une couche de contact CP, qui est formée d'un semi-conducteur monocristallin d'un type de conductivité opposé à celui de la double hétérostructure. Le plus simple est de réaliser cette couche de contact en arsénure de gallium de type P, par épitaxie, d'une épaisseur d'environ 0,2 micromètre.

On décrira maintenant en référence à la figure 4 la réalisastion de la jonction laser P/N, qui est essentielle pour le fonctionnement du dispositif selon l'invention en laser.

Au centre de chaque palier ou terrasse, on réalise une implantation ionique localisée de type P, qui peut donc s'effectuer à travers la couche de contact CP. Les impuretés ainsi "pré-déposées" vont migrer pendant une opération de recuit à l'intérieur de la couche de confinement supérieur, CC4 au niveau de la terrasse T3, CC3 au niveau de la terrasse T2, et CC2 au niveau de la terrasse TI. On réalise alors des régions R3, R2 et RI qui s'étendent à chaque fois dans la couche de confinement supérieure (CC4, CC3, CC2 respectivement), jusqu'au voisinage de la couche active sousjacente (CA3, CA2, CAI, respectivement). Chaque région R3, R2, RI constitue une jonction PN avec la couche active respectivement CA3, CA2, CAI. Ces jonctions J3, J2, JI sont illustrées sur la figure 4, bien qu'elles ne soient pas en pratique repérables optiquement.

Une variante du procédé consiste à réaliser les régions R3, R2, RI par une diffusion localisée de type P.

Le mot "localisée" signifie simplement que la région est diffusée à l'intérieur de la surface de chaque terrasse T3, T2, TI. Cette région peut couvrir la majeure partie ou la quasi-totalité de la surface de la terrasse, ou bien au contraire être réduite à une petite portion centrale de celle-ci, comme illustré ici sur la figure 4.

Comme déjà indiqué, le matériau constitutif est jusqu'à présent toujours du système arsénure de gallium. Les alliages constitutifs des couches actives et de confinement pourront être obtenus par un léger dopage de type P d'un matériau initialement de type N+, par exemple par addition d'impuretés comprises dans le groupe zinc, cadmium, magnésium, béryllium et silicium.

Le zinc et le cadmium sont susceptibles d'être amenés par diffusion ou par implantation ionique. En principe, le béryllium, le manganèse et le silicium ne sont amenés que par implantation ionique, lorsqu'il s'agit de construire une région bien limitée.

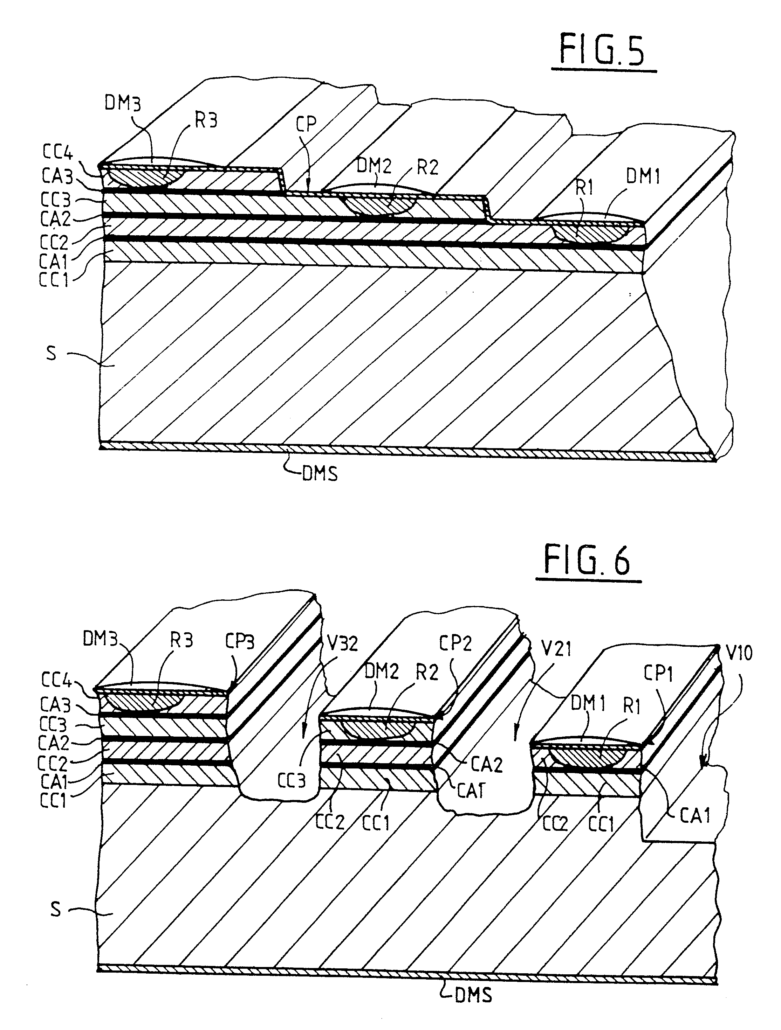

Il est maintenant fait référence à la figure 5. Celle-ci montre qu'on effectue des dépôts métalliques de prise de contact. Il peut s'agir par exemple d'un dépôt d'alliage or-germanium (Au,Ge), sur la semelle du substrat S.

Des dépôts de prise de contact individuels sont effectués en DMI, DM2, DM3, au-dessus de chacune des régions RI, R2, R3. Ces dépôts sont effectués par exemple en alliage or-zinc (Zn, Au).

Il reste alors à délimiter et isoler chaque bande susceptible de fonctionner en diode laser.

Comme illustré sur la figure 6, cela peut se faire en creusant des vallées VI0, V2I, V32, respectivement à droite de la terrasse TI et de la région RI qu'elles logent, entre les terrasses TI et T2, faisant ainsi disparaître la transition MI2, et entre les terrasses T2 et T3, faisant ainsi disparatre la transition M23.

Ces vallées peuvent être obtenues de différentes manières, notamment par voie humide, c'est-à-dire par simple attaque chimique, ou bien par voie sèche, à savoir :

- gravure ionique réactive (RIE, pour Reactive Ion Etching);

- gravure réactive par faisceau d'ions (RIBE pour Reactive Ion Beam Etching);

- gravure ionique excitée par magnétrons (MIE, pour Magnetron Ion Etching); ou

- usinage ionique classique (UI).

Le dispositif ainsi obtenu est susceptible d'un effet laser, et ce avec une longueur d'onde différente pour chacune des régions RI, R2, et R3, dans la mesure où la couche active adjacente n'a pas la même composition dans ces trois cas. On peut donc émettre sélectivement trois longueurs d'ondes différentes à l'aide des trois dispositifs illustrés sur la figure 6, et ce d'une manière qui peut être commandée indépendamment.

Pour manifester l'effet laser, il est nécessaire de préparer optiquement les extrémités opposées des rubans de la figure 6, c'est-à-dire celles que l'on voit en coupe et l'extrémité opposée.

Cette préparation peut être effectuée de manière connue par clivage, ou encore par usinage par voie humide ou voie sèche.

Selon une autre variante de l'invention, l'isolation électrique entre les différentes diodes lasers peut être réalisée par implantation protonique, au lieu de constituer des vallées telles que VI0, V2I et V32.

Bien entendu, l'invention n'est pas limitée au mode de réalisation décrit. On peut par exemple réaliser des structures multi-longueurs d'ondes non seulement dans le système dit GaAs, mais aussi dans le système dit InP (phosphure d'indium), avec des alliages ternaires convenables, ou encore sur tout autre matériau semi-conducteur doué de propriétés optiques radiatives.

Dans la mesure où l'on aura voulu préparer plusieurs dispositifs lasers multi-longueurs d'ondes sur une même plaquette semi-conductrice, le procédé de fabrication comprendra bien sûr une étape supplémentaire, pour la séparation de la structure semi-conductrice en puces individuelles comprenant chacune au moins deux rubans adjacents.

Comme visible sur la figure 6, le dispositif terminal comprend:

- un substrat S;

-au moins deux empilements de double hétérostructure en forme de rubans allongés, disposés côte à côte, isolés électriquement l'un de l'autre, sur le substrat, ces deux empilements possédant un nombre différent de couches actives (CAI, CA2, CA3), et des couches actives supérieures (CAI, CA2, CA3) l'opposé du substrat S, qui sont de composition différente. Les petites extrémités opposées de ces rubans sont préparées optiquement;
- deux régions au moins (RI, R2, R3) présentent respectivement dans les deux couches de confinement supérieures, chacune jusqu'au voisinage de la couche active sous-jacente (CAI, CA2, CA3) pour former avec celle-ci une jonction P-N;

- au moins deux couches de contact (CPI, CP2, CP3) respectivement disposées sur les deux couches de confinement supérieures;

- au moins deux dépôts de contact (DMI, DM2, DM3) sur ces deux couches de contact; et

- un dépot de contact commun (DMS), sur la semelle du substrat.

Un tel dispositif est particulièrement intéressant pour augmenter la capacité de transmission en télécommunications par fibres optiques, ou bien dans les lecteurs de disques otpiques.

## Revendications

I. Procédé de fabrication d'une structure semi-conductrice, en particulier d'une structure susceptible d'effet laser, caractérisé en ce qu'il comporte les opérations suivantes :

a) on dépose sur un substrat (S) un empilement en double hétérostructure monocristalline, constitué de couches actives (CA) de compositions différentes, possédant des propriétés optiques radiatives, et encadrées chacune par deux couches de confinement (CC), possédant une dimension de maille monocristalline voisine de celle des couches actives, toutes ces couches étant du même type de conductivité,

b) on décape sélectivement le dessus de l'empilement, selon des bandes parallèles, adjacentes les unes aux autres, pour y mettre à nu des couches de confinement (CC) qui sont de rangs différents, au moins sur deux bandes adjacentes, les couches de confinement (CC) ainsi mises à nu définissant des terrasses parallèles (TI, T2, T3), séparées les unes des autres par des transitions (MI2, M23),

c) on forme sur ces terrasses une couche de contact (CP),

d) dans une bande incluse dans chaque terrasse, on forme à travers la couche de contact, par introduction d'impuretés correpondant au même type de conductivité que celle-ci, une région (RI, R2, R3) de type inversé qui s'étend dans la couche de confinement supérieure (CC2, CC3, CC4), jusqu'au voisinage de la couche active sous-jacente (CAI, CA2, CA3), pour constituer avec celle-ci une jonction P-N (JI, J2, J3),

e) on effectue un dépôt métallique de contact individuel (DMI, DM2, DM3), sur chaque région de type inversé,

f) on effectue un dépôt métallique de contact commun (DMS), sur le substrat,

g) on isole électriquement les régions de type inversé les unes des autres (VI0, V2I, V32), au niveau des transitions qui les séparent, pour former des rubans de structure semi-conductrice, et

h) on prépare optiquement les extrémités opposées de ces rubans transversalement à la plus grande dimension des terrasses.

2. Procédé selon la revendication I, caractérisé en ce que les matériaux constituant la double hétérostructure sont des alliages III-V.

3. Procédé selon la revendication 2, caractérisé en ce que les matériaux constituant la double hétérostructure sont des alliages d'au moins un matériau du groupe : aluminium, gallium, et indium; et d'au moins un matériau du groupe : phosphore, arsenic, antimoine.

4. Procédé selon la revendication 3, caractérisé en ce que les couches actives, de type N, ont pour composition $Ga_{1-x} Al_x As$, x différant à chaque fois, et étant inférieur à I0% environ, tandis que les couches de confinement ont pour composition $Ga_{1-y} Al_y As$, y étant sensiblement le même pour toutes, et égal à 30% environ.

5. Procédé selon l'une des revendications précédentes, caractérisé en ce que les couches de la double hétérostructure sont déposées par épitaxie, en particulier par épitaxie en phase liquide, ou encore par épitaxie par jet moléculaire, ou bien par dépôt en phase vapeur de composés organo-métalliques.

6. Procédé selon l'une des revendications précédentes, caractérisé en ce que l'épaisseur des couches actives est de l'ordre du dixième de micromètre, tandis que celle des couches de confinement est de l'ordre du micromètre.

7. Procédé selon l'une des revendications précédentes, caractérisé en ce que l'opération b) de décapage, réalisée par photogravure, écarte une partie de l'épaisseur de la couche de confinement à laquelle elle s'arrête, et en ce que l'opération c) consiste à déposer une couche de contact par épitaxie.

8. Procédé selon la revendication 7, caractérisé en ce que l'épaisseur résiduelle de ladite couche de confinement est d'environ I micro-mètre.

9. Procédé selon l'une des revendications précédentes, caractérisé en ce que la couche de contact est également un alliage III-V.

10. Procédé selon la revendication 9, prise en combinaison avec la revendication 4, caractérisé en ce que la couche de contact est en arséniure de gallium de type P.

11. Procédé selon l'une des revendications I à 6, caractérisé en ce que l'étape b) de décapage est arrêtée au niveau supérieur de chacune des couches actives, celles-ci servant alors de couches de contact.

12. Procédé selon l'une des revendications précédentes, caractérisé en ce que ladite région est formée à l'aide d'impuretés choisies dans le groupe comprenant : zinc, cadmium, magnésium et Béryllium.

13. Procédé selon l'une des revendications précédentes, caractérisé en ce que ladite région est formée par implantation ionique suivie de recuit.

14. Procédé selon l'une des revendications I à 12, caractérisé en ce que ladite région est formée par diffusion.

15. Procédé selon l'une des revendications précédentes, caractérisé en ce que ladite région est localisée, n'intéressant qu'une petite partie de la surface de la terrasse.

16. Procédé selon l'une des revendications précédentes, caractérisé en ce que l'opération g) d'isolation des terrasses est réalisée par un décapage localisé, par voie sèche ou humide, gravant des sillons jusqu'au substrat.

17. Procédé selon l'une des revendications I à 15, caractérisé en ce que l'opération g) d'isolation des terrasses est réalisée par implantation protonique.

18. Procédé selon l'une des revendications précédentes, caractérisé en ce que l'opération h) de préparation optique comprend un clivage.

19. Procédé selon l'une des revendications précédentes, caractérisé en ce que l'opération h) de préparation optique comprend un usinage par voie humide ou sèche.

20. Procédé selon l'une des revendications précédentes, caractérisé en ce que le substrat est un alliage III-V fortement dopé N ou bien du Silicium.

21. Procédé selon l'une des revendications précédentes, caractérisé en ce qu'il comprend l'opération supplémentaire suivante :

i) séparer la structure semi-conductrice en puces individuelles comprenant chacune au moins deux rubans adjacents.

22. Dispositif semi-conducteur obtenu par le procédé de l'une des revendications précédentes.

23. Dispositif selon la revendication 22, caractérisé en ce qu'il comprend:

- un substrat,

- au moins deux empilements de double hétérostructure en forme de rubans allongés, disposés côte à côte, isolés électriquement l'un de l'autre, sur le substrat, ces deux empilements possédant un nombre différent de couches actives, de composition différente, et les petites extrémités opposées de ces rubans étant préparées optiquement;

- deux régions, présentes respectivement dans les deux couches de confinement supérieures, chacune jusqu'au voisinage de la couche active sous-jacente, pour former avec celle-ci une jonction P-N,

- deux couches de contact respectivement disposées sur les deux couches de confinement supérieures,

- deux dépôts de contact sur ces deux couches de contact, et

- un dépôt de contact sur le substrat.

24. Application du dispositif selon la revendication 22, en tant que laser à semi-conducteur multi-longueurs d'onde.

0267839

FIG.1

CC4
CA3
CC3
CA2
CC2
CA1
CC1
S

FIG.2

T3   M23   T2

CC4   M12   T1   CC2
CA3   CA1
CC3   CC1
CA2   S

FIG.3

CP

CC4   CC2
CA3   CA1
CC3   CC1
CA2   S

FIG.4

CP

R3   J3

CC4   R2   J2

CA3   R1   J1

CC3

CA 2   CA1

CC2   CC1

S

0267839

## FIG.5

## FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENT ABSTRACTS OF JAPAN, vol. 5, no. 167 (E-79)[839], 24 octobre 1981; & JP-A-56 96 881 (FUJITSU K.K.) 05-08-1981 * Résumé * --- | 1-5,7, 12,14, 15,22- 24 | H 01 L 33/00 H 01 L 27/15 H 01 S 3/23 |
| X | ELECTRONICS LETTERS, vol. 18, no. 1, 7 janvier 1982, pages 18-20, Londres, GB; S. SAKAI et al.: "Dual wavelength InGaAsP/InP TJS lasers" * En entier * --- | 1-3,5-7 ,12,14, 22-24 | |
| X | ELECTRONICS LETTERS, vol. 18, no. 1, 7 janvier 1982, pages 17,18, Londres, GB; S. SAKAI et al.: "InGaAsP/InP dual wavelength lasers" * En entier * --- | 1-3,5-7 ,22-24 | |
| A | EP-A-0 091 859 (N. BOUADMA et al.) * Page 3, ligne 14 - page 7, ligne 28; revendications; figures * --- | 1-5,7, 17-19, 21-24 | |
| A | PATENT ABSTRACTS OF JAPAN, vol. 5, no. 23 (E-45)[695], 12 février 1981; & JP-A-55 148 477 (SANYO DENKI K.K.) 19-11-1980 * Résumé * --- | 1-3,5,7 ,22,23 | H 01 L H 01 S |
| A | WO-A-8 200 921 (WESTERN ELECTRIC) * Revendications; figures * --- | 1-5,12, 14,16, 22-24 | |
| A | PATENT ABSTRACTS OF JAPAN, vol. 9, no. 204 (E-337)[1927], 21 août 1985; & JP-A-60 66 889 (MATSUSHITA DENKI SANGYO K.K.) 17-04-1985 * Résumé * --- | 1,16,21 -24 | |

DOMAINES TECHNIQUES RECHERCHES (Int. Cl.4)

-/-

Le présent rapport a été établi pour toutes les revendications

| Lieu de la recherche | Date d'achèvement de la recherche | Examinateur |
|---|---|---|
| LA HAYE | 27-01-1988 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................
& : membre de la même famille, document correspondant

EPO FORM 1503 03.82 (P0402)

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 001 375  (IBM)<br>* Revendications; figures *<br><br>--- | 1-5,12-14,22-24 | |
| A | WO-A-8 602 491  (AMERICAN TELEPHONE & TELEGRAPH CO.)<br>* Revendications; figures *<br>----- | 1-5,22-24 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| LA HAYE | 27-01-1988 | VISENTIN A. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
............................................................
& : membre de la même famille, document correspondant

EPO FORM 1503 03.82 (P0402)